# FASCICULE DE BREVET EUROPEEN

(11) **EP 3 670 441 B1**
(45) Date de publication et mention de la délivrance du brevet: **09.04.2025**
(21) Numéro de dépôt: 18215108.4
(22) Date de dépôt: 21.12.2018
(51) Int. Cl.: B81C 99/00, C25D 1/00, G03F 7/00

(54) **PROCÉDÉ DE FABRICATION D'UN COMPOSANT HORLOGER**
VERFAHREN ZUR HERSTELLUNG EINER UHRENKOMPONENTE
METHOD FOR MANUFACTURING A CLOCK COMPONENT

(43) Date de publication de la demande: 24.06.2020
(73) Titulaire: ROLEX SA, 1211 Genève 26 (CH)
(72) Inventeur: CALAME, Florian, CH- 1066 Épalinges (CH); MAEGLI, Alexandra, CH- 1211 Genève 26 (CH); MULTONE, Xavier, CH- 1005 Lausanne (CH)
(74) Mandataire: Moinas & Savoye SARL

(56) Documents cités:
- EP-A1- 2 405 300
- EP-A1- 3 260 932
- WO-A1-2017/148394
- US-A1- 2003 057 096
- CARSTEN ESCHENBAUM ET AL: "Hybrid lithography: Combining UV-exposure and two photon direct laser writing", OPTICS EXPRESS, vol. 21, no. 24, 26 November 2013 (2013-11-26), XP055413901, DOI: 10.1364/OE.21.029921

## Description

La présente invention concerne un procédé de fabrication d'un master prévu pour permettre la fabrication d'un moule de composant horloger, et un procédé de fabrication d'un composant horloger. Autrement dit, la présente invention concerne un procédé de fabrication d'un master pour moule de composant horloger et un procédé de fabrication d'un composant horloger.

La photolithographie est une technologie couramment utilisée pour la fabrication de composants horlogers, permettant particulièrement de former un moule en résine utilisé pour la fabrication des composants horlogers.

Le brevet EP2405300 décrit, par exemple, la réalisation d'un procédé de fabrication d'une pièce métallique à au moins deux niveaux exploitant la technologie de photolithographie.

Le document EP3035125 propose un procédé amélioré de fabrication d'un composant horloger présentant plusieurs niveaux exploitant la technologie de photolithographie.

Le document EP3260932 décrit un procédé de fabrication d'un composant horloger en céramique polycristalline, dans lequel un moule formé par photolithographie est utilisé.

Ces approches de l'état de la technique basées sur une photolithographie dite traditionnelle présentent toutefois l'inconvénient de ne pas permettre la réalisation de toute forme tridimensionnelle, comme des formes complexes à une échelle micrométrique, voire nanométrique.

Par ailleurs, le terme « soft-lithography » est utilisé pour décrire un procédé permettant d'obtenir un moule constitué d'un matériau souple à partir d'un master fabriqué par exemple par un procédé de photolithographie traditionnel.

Un tel procédé de l'état de la technique présente toutefois l'inconvénient de ne pas permettre la réalisation de toute forme tridimensionnelle, comme des formes complexes à une échelle micrométrique, voire nanométrique. Le document WO 2017/148394 A1 décrit une méthode dans laquelle une résine photosensible est recouverte par un photomasque au cours d'un processus de photolithographie. La résine photosensible exposée fournit alors une structure de support pour l'étape suivante d'écriture laser par absorption à deux photons. Un faisceau laser provenant d'un dispositif d'écriture laser à absorption à deux photons est utilisé pour exposer le contour d'un composant, dans cet exemple le contour de la forme d'une vis de balancier. Une fois que le substrat à motifs a été cuit, la résine photosensible ayant été exposée par le faisceau laser à deux photons le long du contour de la vis de balancier sera réticulée, de manière à former une coquille fermée. La résine photosensible est ensuite développée dans un révélateur, ce qui permet d'obtenir un moule de résine photosensible présentant les caractéristiques géométriques requises pour la vis d'équilibrage. Le substrat est alors prêt à être placé dans une cuve d'électroformage.

Ainsi, la présente invention a pour objet d'améliorer les procédés connus de l'art antérieur et de proposer une solution de fabrication d'un composant horloger tridimensionnel, éventuellement de forme complexe à une échelle micrométrique, voire nanométrique. Elle a aussi pour objet de permettre la fabrication d'un composant horloger avec une grande fiabilité, une grande répétabilité, et une grande précision.

A cet effet, l'invention concerne un procédé de fabrication d'un master prévu pour permettre la fabrication d'un moule de composant horloger, et un procédé de fabrication d'un composant horloger.

Le procédé de fabrication d'un master pour moule de composant horloger, comprend entre autres les étapes suivantes:
- Fabriquer une première structure à partir d'une première résine photosensible comprenant au moins une couche de résine photosensible comprenant un premier motif obtenu par polymérisation de la première résine photosensible par irradiation à travers au moins un masque, puis développement de ladite première résine photosensible ;
- Transformer la première structure en une deuxième structure par une structuration d'au moins une surface de la première structure par ajout d'une deuxième résine photosensible sur ladite au moins une surface. Cette étape utilise avantageusement la technologie de polymérisation à deux photons.

L'invention est définie par la revendication 1.

Ces objets, caractéristiques et avantages de la présente invention seront exposés en détail dans la description suivante de modes de réalisation particuliers faits à titre non-limitatif en relation avec les figures jointes parmi lesquelles :
La figure 1 représente une vue en perspective d'un cliquet d'automate réalisé par un procédé de fabrication selon un mode de réalisation de l'invention.
La figure 2 représente une vue en perspective agrandie d'une ouverture du cliquet de la figure 1, réalisée par un procédé de fabrication selon un mode de réalisation de l'invention.
Les figures 3 à 9 illustrent les étapes successives d'un procédé de fabrication d'un master prévu pour permettre la fabrication d'un moule du cliquet d'automate représenté par les figures 1 et 2 selon un premier mode de réalisation de l'invention.
La figure 10 illustre une étape de fabrication d'un moule du cliquet d'automate sur la base dudit master résultant des étapes illustrées par les figures 3 à 9.
La figure 11 illustre une étape de fabrication du cliquet d'automate sur la base du moule obtenu notamment à l'issue de l'étape illustrée par la figure 10.
Les figures 12 à 16 illustrent les étapes successives d'un procédé de fabrication d'un master prévu pour permettre la fabrication d'un moule du cliquet d'automate représenté par les figures 1 et 2 selon un deuxième mode de réalisation de l'invention.
La figure 17 illustre une étape de fabrication d'un moule du cliquet d'automate sur la base dudit master résultant des étapes illustrées par les figures 12 à 16.
La figure 18 illustre une étape de fabrication du cliquet d'automate sur la base du moule obtenu notamment à l'issue de l'étape illustrée par la figure 17.

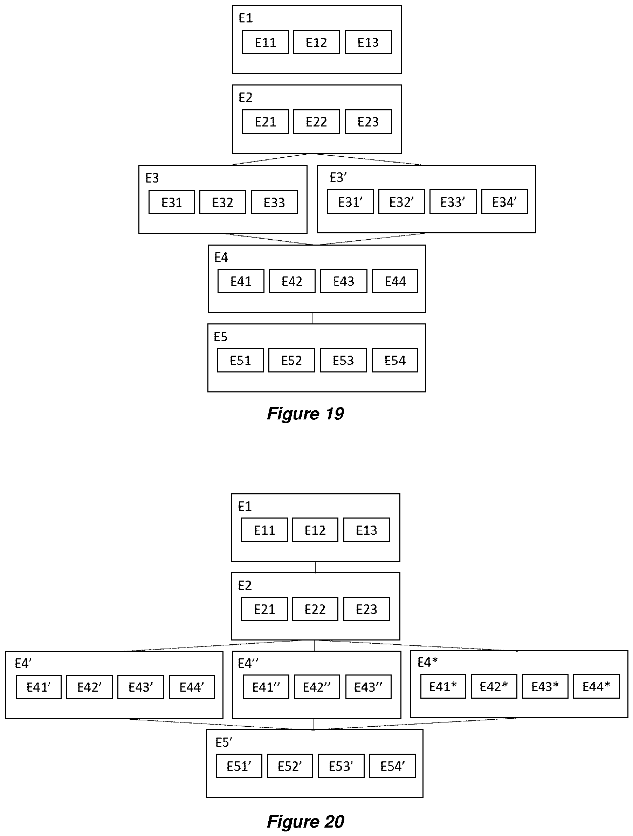

La figure 19 illustre un logigramme représentant schématiquement les étapes et sous-étapes de première et deuxième variantes du premier mode de réalisation.
La figure 20 illustre un logigramme représentant schématiquement les étapes et sous-étapes de première, deuxième et troisième variantes du deuxième mode de réalisation.

L'invention met notamment en œuvre un procédé de fabrication d'un master prévu pour permettre la fabrication d'un moule de composant horloger, qui combine avantageusement au moins une étape basée sur une photolithographie traditionnelle et au moins une étape basée sur la technologie de polymérisation à deux photons, connue par son sigle anglo-saxon TPP pour « two-photons polymerization ». Ce procédé est, par exemple, utilisé dans le procédé décrit par le document US9302430, dans un domaine éloigné de l'horlogerie. Il s'apparente finalement à une photolithographie particulière, tridimensionnelle, très différente de la photolithographie traditionnelle.

Plus particulièrement, l'invention met en œuvre un procédé de fabrication comprenant au moins une première étape consistant à fabriquer E1 une première structure sur un substrat, en utilisant la technologie de photolithographie traditionnelle, et une deuxième étape consistant avantageusement à transformer E2 la première structure en une deuxième structure, par une structuration d'au moins une surface de la première structure en utilisant la technologie de polymérisation à deux photons.

Dans un premier mode de réalisation de l'invention, le procédé de fabrication comprend, outre les première et deuxième étapes E1 et E2 :
- Une troisième étape consistant à fabriquer E3, E3' un master 2 prévu pour permettre la fabrication d'un moule 3 de composant horloger 6 ;
- Une quatrième étape consistant à fabriquer E4 ledit moule 3 ;
- Et une étape consistant à fabriquer E5 ledit composant horloger 6.

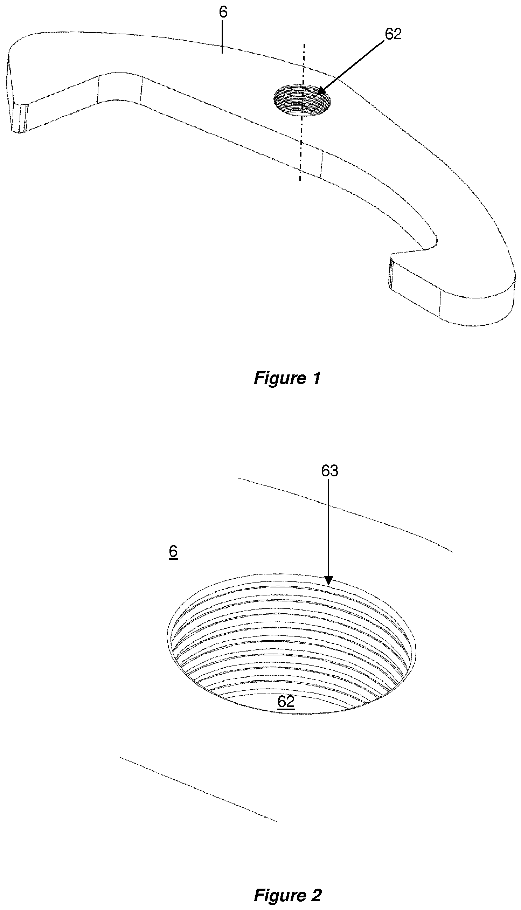

Le procédé de fabrication selon une première variante du premier mode de réalisation de l'invention va être illustré dans le cadre de la fabrication d'un cliquet d'automate 6 représenté par les figures 1 et 2. Ce cliquet d'automate 6 est, par exemple, réalisé en une céramique technique, préférentiellement une céramique telle qu'une zircone yttriée, et comprend une ouverture 62 dont la paroi comprend des microstructures 63 qui sont adaptées pour amoindrir, par exemple, les surfaces de contact entre ladite paroi de l'ouverture 62 du cliquet et le moyen de guidage avec lequel elle coopère. Ce cliquet, et notamment la paroi microstructurée de l'ouverture 62, présente une géométrie très complexe, qui peut avantageusement être obtenue par le procédé de fabrication selon le premier mode de réalisation.

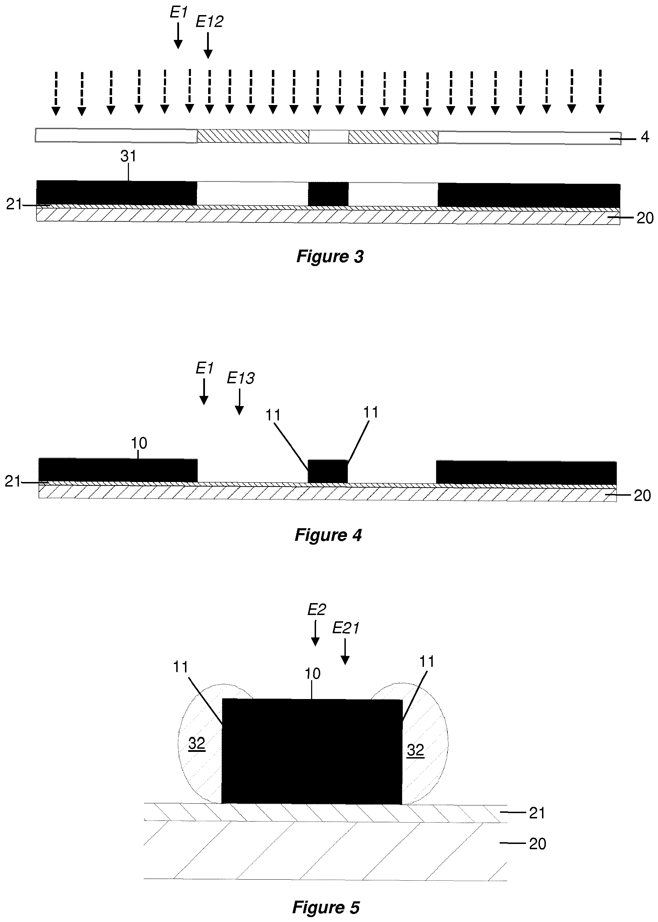

Nous allons maintenant décrire un premier mode de réalisation d'un procédé de fabrication d'un master prévu pour permettre la fabrication d'un moule de composant horloger, et un procédé de fabrication d'un composant horloger utilisant le moule obtenu à partir dudit master, en référence avec les figures 3 à 11, particulièrement adapté à la fabrication d'un cliquet d'automate tel que décrit ci-dessus, et plus généralement adapté à la fabrication de tout composant horloger.

Le procédé comprend une première étape consistant à fabriquer E1 une première structure 10 sur un substrat 20, en utilisant la technologie de photolithographie traditionnelle.

Par convention, nous définissons la direction horizontale comme une direction parallèle au plan du substrat 20. Nous définissons la direction verticale comme la direction perpendiculaire à la direction horizontale, donc perpendiculaire au plan du substrat.

Ce substrat 20 peut se présenter sous la forme d'une plaquette en métal, comme un acier inoxydable, ou se présenter sous la forme d'une plaquette en silicium, ou en verre ou en céramique. Il est avantageusement plan. Il peut optionnellement comprendre des structures qui sont réalisées, par exemple, par usinage laser. Ces structures peuvent, par exemple, comprendre des motifs, notamment des motifs usinés, et/ou des cavités. Le substrat est préparé selon les règles connues de l'homme de l'art, notamment pour son dégraissage, son nettoyage, éventuellement sa passivation et/ou son activation. Préférentiellement, le substrat 20 est muni de repères de sorte à pouvoir être positionné très précisément. Le substrat 20 peut être fabriqué dans un matériau conducteur, par exemple un acier inoxydable. En variante, on pourrait aussi utiliser un substrat en un matériau non-conducteur, comme par exemple le silicium. Dans ce cas, une couche conductrice 21 peut être déposée sur la surface supérieure du substrat 20, par exemple par évaporation thermique, dans une étape préliminaire mise en œuvre avant la première étape E1. De façon connue, cette couche conductrice 21 d'amorçage peut comprendre une sous-couche de chrome, de nickel ou de titane recouverte d'une couche d'or ou de cuivre, et se présenter ainsi sous la forme d'une structure multicouche.

La première étape comprend une sous-étape consistant à déposer E11 une première résine photosensible 31 de sorte à recouvrir tout ou partie de la couche conductrice 21 du substrat 20 (ou directement la surface supérieure du substrat 20 en l'absence de couche conductrice 21) d'une couche d'une première résine photosensible 31 sur une hauteur souhaitée, selon les règles connues de l'homme de l'art. Cette première résine photosensible 31 est adaptée à la photolithographie traditionnelle. Elle peut être négative ou positive. Dans le premier cas, elle est conçue pour devenir insoluble ou difficilement soluble à un révélateur sous l'action d'un rayonnement (i.e. les zones exposées résistent au développement), alors que, dans le second cas, elle est conçue pour devenir soluble à un révélateur sous l'action d'un rayonnement, alors que la partie non exposée au rayonnement reste insoluble ou difficilement soluble. Cette résine photosensible 31 peut être de type « SU-8 », qui est une résine photosensible négative qui polymérise sous l'action d'un rayonnement UV, par exemple la résine SU-8-100 de la maison Microchem.

La première étape comprend ensuite une sous-étape consistant à exposer E12 la première résine photosensible 31 à travers un masque 4, notamment par un rayonnement UV, des rayons X ou un faisceau d'électrons, selon une direction sensiblement perpendiculaire au masque, pour la polymériser selon un premier motif défini par le masque 4, comme illustré par la figure 3. Cette exposition consiste à exposer à une radiation lumineuse ou à insoler la couche de résine photosensible 31 à travers le masque 4 comprenant des ouvertures et des zones opaques. Ce masque définit ainsi le premier motif à reproduire pour la réalisation de la structure ou d'une portion de structure. Les rayonnements utilisés sont perpendiculaires ou sensiblement perpendiculaires au plan dans lequel s'étend le masque, et perpendiculaires ou sensiblement perpendiculaires au substrat 20, de manière à n'irradier que les zones de la résine situées au droit des ouvertures ménagées dans le masque. Ces zones sont ainsi définies par des parois verticales ou sensiblement verticales, à savoir perpendiculaires ou sensiblement perpendiculaires au plan du substrat 20. Alternativement, un masque à variation de transmittance peut être employé de sorte à former des parois non verticales ou inclinées.

Ensuite, la première étape comprend une sous-étape consistant à développer E13 la première résine photosensible 31. Dans le mode de réalisation où la résine 31 est négative, le développement consiste à éliminer les zones de résine non exposées (i.e non insolées), selon un procédé adapté à la résine photosensible 31, par exemple par dissolution avec un produit chimique ou par un procédé plasma. En variante, dans le cas d'une résine photosensible positive, les zones insolées sont éliminées lors du développement par exemple par voie chimique et les zones non insolées sont conservées sur le substrat. Après le développement, la surface supérieure du substrat 20 ou l'optionnelle couche conductrice 21 apparaît aux endroits où la résine a été éliminée. Les parties restantes de résine forment ainsi une première structure 10, illustrée par la figure 4. Cette structure repose sur la surface supérieure du substrat 20 ou de l'éventuelle couche conductrice 21 du substrat 20. La première structure 10 s'étend donc entre deux surfaces horizontales, supérieure (définie comme l'interface entre la résine polymérisée et l'air) et inférieure (définie comme l'interface entre la résine polymérisée et la surface supérieure du substrat 20 ou de l'optionnelle couche conductrice 21), et comprend des surfaces latérales 11, s'étendant entre ces deux surfaces horizontales, en général sensiblement verticales mais pouvant être en variante inclinées. Ces surfaces latérales résultent des ouvertures formées dans la première résine photosensible 31 par le retrait de résine photosensible non polymérisée, par la photolithographie traditionnelle. De préférence, la première structure 10 présente une hauteur constante (mesurée entre les deux surfaces supérieure et inférieure).

Afin de créer une structure à plusieurs niveaux, la première étape E1 peut comprendre la répétition des sous-étapes décrites précédemment, avec différents masques, figurant différents sous-premiers motifs, dont la résultante figure la première structure selon un premier motif correspondant à l'association des différents sous-premiers motifs.

Le procédé comprend ensuite une deuxième étape consistant à transformer E2 la première structure 10 en une deuxième structure 1, par une structuration d'au moins une surface de la première structure 10, notamment au moins une surface latérale 11 de la première structure 10. Cette étape comprend l'ajout d'un deuxième motif tridimensionnel 12 en résine polymérisée sur ladite au moins une surface.

La deuxième étape comprend ainsi une sous-étape consistant à déposer E21 une couche d'une deuxième résine photosensible 32 liquide ou semi-liquide sur au moins une partie de l'au moins une surface susmentionnée de la première structure 10, notamment sur au moins une surface latérale 11, comme illustré par la figure 5. Cette étape peut, par exemple, être effectuée par « drop casting » ou tout autre moyen permettant de déposer de la résine liquide ou semi-liquide (« spray coating », « spin coating »...). La deuxième résine photosensible 32 est particulièrement adaptée à la technologie de polymérisation à deux photons mentionnée précédemment. Elle peut être négative ou positive. Dans une forme d'exécution particulière, la résine photosensible 32 utilisée est une résine semi-liquide, par exemple une résine IP-Dip^{™} de la maison Nanoscribe, qui est une résine négative. Le mode de réalisation ne se limite pas à la description ci-dessus. La surface susmentionnée de la première structure pourrait en variante ou complément être horizontale, et non uniquement une surface latérale, notamment dans le cas d'une fabrication d'un composant horloger multiniveaux. Alternativement, les première et deuxième résines photosensibles 31, 32 peuvent être identiques. La résine alors employée pour les deux étapes E1, E2 est adaptée aussi bien à la photolithographie traditionnelle qu'à la technologie de polymérisation à deux photons.

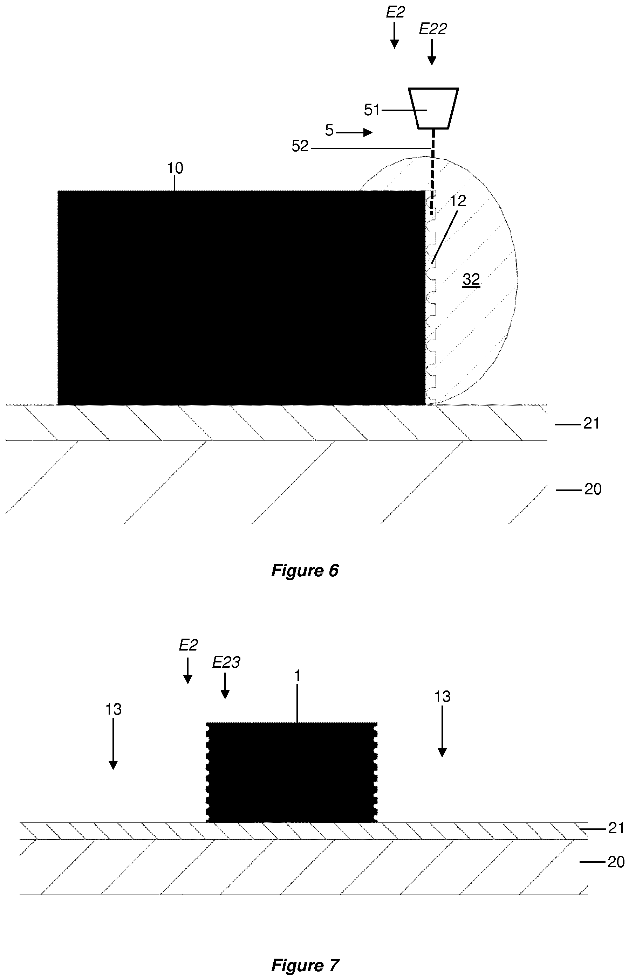

La deuxième étape comprend ensuite une sous-étape consistant à polymériser à deux photons E22 au moins une partie de la couche de la deuxième résine photosensible 32, comme illustré par la figure 6, pour obtenir une polymérisation tridimensionnelle selon un deuxième motif tridimensionnel prédéfini. Pour cela, le procédé peut utiliser un dispositif photonique 5, qui est prévu pour émettre des ondes électromagnétiques sur ou dans la résine photosensible 32, de sorte à la polymériser selon des coordonnées spatiales qui correspondent au deuxième motif. Les intérêts de ce procédé sont la précision de la définition et la complexité des motifs réalisables, comme notamment des motifs non continus selon la direction verticale.

Selon l'invention, le dispositif photonique 5 comporte un objectif 51 qui est au moins partiellement immergé dans la deuxième résine photosensible 32 de sorte à la polymériser selon des coordonnées spatiales définissant la forme ou géométrie tridimensionnelle 12 du deuxième motif.

Cela permet avantageusement d'optimiser la résolution du deuxième motif tridimensionnel. Plus particulièrement, l'objectif 51 est prévu pour diriger et focaliser un faisceau laser 52 de sorte que le point focal passe par les différentes coordonnées spatiales définissant la forme ou la géométrie 12 du deuxième motif. Pour chacune des coordonnées, deux photons peuvent simultanément être absorbés par la résine 32 dans un très petit volume appelé "voxel" au point focal du laser 52. Une réaction chimique est initiée, la résine liquide ou semi-liquide polymérise et devient solide à l'intérieur du voxel. Les voxels résultant du parcours de focalisation du faisceau laser 52 définissent ainsi la forme ou la géométrie 12 du deuxième motif. En combinant avantageusement l'optique de focalisation du laser et le matériau de la résine photosensible 32, le diamètre du voxel peut être inférieur à 0.1 µm, et permet donc de définir des microstructurations voire des nanostructurations de très haute résolution sur la au moins une surface, notamment sur la au moins une surface latérale 11, de la première structure 10. Cette étape permet ainsi de définir un deuxième motif selon une résolution tridimensionnelle inférieure ou égale à 0.001 µm³ et une résolution latérale équivalente au diamètre du voxel, soit inférieure ou égale à 0.1 µm.

D'autre part, comme représenté par la figure 6, ce deuxième motif peut s'étendre au moins en partie dans une direction horizontale, ou présentant une composante horizontale significative, à partir d'un dépôt de deuxième résine photosensible 32 sur une surface latérale 11 de la première structure 10, notamment sur une surface perpendiculaire ou sensiblement perpendiculaire au substrat 20.

Cette étape peut donc former des microstructurations, voire des nanostructurations, qui peuvent, par exemple, prendre la forme de créneaux ou d'escaliers 12 sur la surface 11, comme illustré par la figure 7. Ces formes ne creusent pas la surface 11, mais sont disposées en relief sur la surface 11.

La deuxième étape comprend ensuite une sous-étape consistant à développer E23 la deuxième résine photosensible 32 pour éliminer la deuxième résine photosensible 32 non polymérisée et obtenir la deuxième structure 1 de forme définie par les premier et deuxième motifs. En effet, une fois la deuxième résine photosensible 32 polymérisée selon la géométrie tridimensionnelle prédéfinie, les zones de résine photosensible 32 non exposées sont éliminées dans le cas d'une résine photosensible négative, par exemple par dissolution avec un produit chimique ou par un procédé plasma. Préférentiellement, le produit chimique utilisé est le même que celui exploité lors de la première étape. Celui-ci peut, par exemple, être un solvant à base de PGMEA.

A la fin de cette deuxième étape, l'assemblage des deux résines photosensibles 31, 32 mises en forme selon respectivement les deux motifs susmentionnés forme finalement une deuxième structure 1 solidaire du substrat 20.

Selon le premier mode de réalisation, cette deuxième structure 1 est destinée à former, complémentairement avec le substrat 20, un premier moule de fabrication d'un master prévu pour fabriquer un deuxième moule de fabrication d'un composant horloger. Dans ce premier mode de réalisation, la deuxième structure 1 peut comprendre au moins une cavité 13.

Du fait des étapes E1, E2 du procédé décrites ci-dessus, il est possible de former une deuxième structure 1 présentant toute forme tridimensionnelle complexe, et donc par conséquent permettant de former tout master pour moule de composant horloger de forme tridimensionnelle complexe correspondante.

Le procédé met alors en œuvre une troisième étape consistant à utiliser E3, E3' la deuxième structure 1 pour fabriquer un master prévu pour fabriquer un moule de fabrication d'un composant horloger.

Plus particulièrement, cette troisième étape E3, E3' consiste à utiliser la deuxième structure 1, complémentairement avec le substrat 20, comme moule pour la fabrication d'un master 2 prévu pour fabriquer un deuxième moule 3 destiné à la fabrication directe d'un composant horloger 6.

Ce master 2 peut notamment comprendre du métal ou un alliage métallique, ou de la céramique ou un matériau composite. Préférentiellement, le master 2 comprend le substrat 20.

Selon une première variante décrite ci-après du premier mode de réalisation, le master 2 résulte d'une croissance d'une couche 22 de métal ou d'un alliage de métal sur le substrat 20. Ainsi, le master est préférentiellement constitué du substrat 20, de l'éventuelle couche 21, et de la couche 22 de métal ou de l'alliage de métal ayant crû sur ledit substrat. Alternativement, le master 2 ne comprend pas le substrat 20 et prend la forme de la couche 22 de métal ou de l'alliage de métal ayant crû sur le substrat, cette dernière étant préalablement séparée dudit substrat.

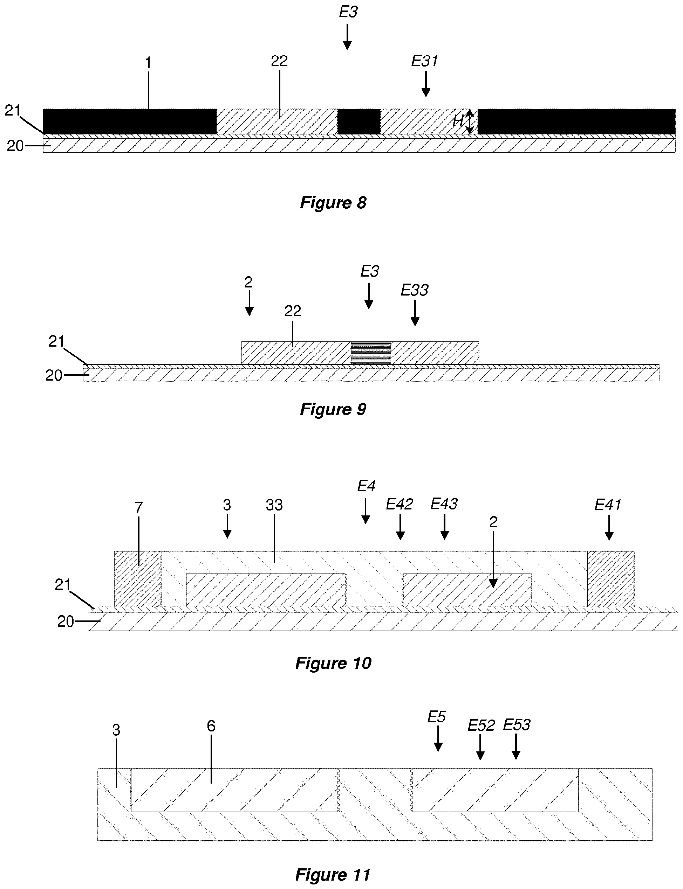

Dans cette première variante de réalisation, la troisième étape comprend une sous-étape consistant à déposer E31 une couche de métal 22 formant au moins partiellement le master 2, par électrodéposition ou dépôt galvanique, dans la ou les cavités 13 de la deuxième structure 1, comme illustré par la figure 8. Dans cette sous-étape, la couche conductrice 21 susmentionnée ou le substrat 20 lui-même s'il est dans un matériau conducteur, joue le rôle de cathode pour amorcer le dépôt. Cette étape utilise, par exemple, le procédé LIGA et un métal ou un alliage de métal tel que, par exemple, le nickel (Ni) ou le nickel-phosphore (NiP) ou tout alliage à base de nickel. Avantageusement, un alliage tel que décrit par le document WO2017102661 peut être employé. La couche de métal 22 obtenue a préférentiellement la même hauteur H que celle du moule formé par la deuxième structure 1. Elle peut aussi avoir une hauteur inférieure à la hauteur du moule, voire une hauteur supérieure à la hauteur du moule. De façon optionnelle, cette sous-étape peut comprendre une mise de hauteur, par polissage mécanique simultané de la couche métallique et du moule, pour obtenir une surface supérieure parfaitement plane, horizontale.

Par ailleurs, la couche de métal 22 obtenue a préférentiellement une hauteur H sensiblement supérieure à celle de la couche 21. Elle est préférentiellement supérieure à cinq fois la hauteur de la couche 21, voire supérieure à dix fois la hauteur de la couche 21.

Dans cette première variante de réalisation, la troisième étape peut comprendre une sous-étape optionnelle consistant à séparer E32 l'ensemble formé par ladite couche de métal 22 et la deuxième structure 1 du substrat 20, par exemple par délamination de la couche conductrice 21 du substrat.

Dans cette première variante de réalisation, la troisième étape comprend une sous-étape consistant à séparer E33 le master 2, formé notamment par ladite couche de métal 22, de la deuxième structure 1, par exemple par attaque chimique ou à l'aide d'un plasma, pour atteindre le résultat représenté par la figure 9.

L'éventuelle sous-étape E32 et la sous-étape E33 peuvent être réalisées dans un ordre quelconque.

Selon une deuxième variante décrite ci-après du premier mode de réalisation, le master 2 résulte d'une formation d'une couche de céramique sur le substrat 20. Ainsi, le master est préférentiellement constitué du substrat 20, de l'éventuelle couche 21, et de la couche de céramique formée sur ledit substrat. Alternativement, le master 2 ne comprend pas le substrat 20 et prend la forme de la couche de céramique sur le substrat, cette dernière étant préalablement séparée dudit substrat.

Dans cette deuxième variante de réalisation, la troisième étape E3' comprend une sous-étape consistant à remplir E31' la deuxième structure 1 par voie liquide d'un produit comprenant de la poudre de céramique. Cette étape peut, par exemple, comprendre le coulage d'une barbotine ou le coulage d'un gel ou un coulage de coagulation. Alternativement, cette étape peut être mise en œuvre par électrophorèse dans le cas d'un substrat fait en un matériau conducteur ou dont la surface supérieure du substrat est recouverte d'une couche 21 conductrice. Dans le cas d'une barbotine, cette dernière peut comprendre une matière liquide, de la poudre de céramique et au moins un adjuvant. La matière liquide peut comprendre de l'eau, un alcool ou un autre solvant organique. La poudre de céramique peut, par exemple, comprendre une zircone, ou une alumine, ou un oxyde, ou un carbure, ou un nitrure. Cette étape peut être réalisée sous vide pour garantir un remplissage parfait sans inclusion d'air.

Cette sous-étape E31' peut être précédée par une sous-étape facultative consistant à préparer au moins une portion de surface de substrat 20 en regard d'au moins une cavité 13 de la deuxième structure 1 ou à déposer un revêtement sur au moins une portion de surface de substrat 20 en regard d'au moins une cavité 13 de la deuxième structure 1, dans le but de faciliter la libération future d'une ébauche du master 2 du substrat 20. En remarque, cette ébauche peut, par exemple, prendre la forme du corps vert préfigurant le master 2.

Dans cette deuxième variante de réalisation, la troisième étape comprend une sous-étape consistant à consolider E32' le produit positionné dans la deuxième structure 1. Cette sous-étape peut notamment comprendre le séchage de la barbotine afin d'obtenir une ébauche du master 2.

Une sous-étape intermédiaire facultative peut consister en la mise de hauteur de l'ébauche du master 2, avant libération du moule. Cette ébauche peut, par exemple, prendre la forme du corps vert préfigurant le master 2.

Dans cette deuxième variante de réalisation, la troisième étape comprend une sous-étape consistant à séparer E33' l'ébauche de master du moule de fabrication formé par la deuxième structure 1. Cette séparation peut, par exemple, être réalisée par attaque chimique ou par traitement à l'aide d'un plasma.

Dans cette deuxième variante de réalisation, la troisième étape comprend enfin une sous-étape consistant à délianter l'ébauche obtenue à l'étape précédente puis à la densifier E34' par frittage. Préférentiellement, le substrat 20 est fait en un matériau prévu pour supporter les températures auxquelles sont effectuées les sous-étapes de la troisième étape E3'. Par exemple, le substrat peut être en silicium ou en alumine. Alternativement, le master 2 ne comprend pas le substrat 20 et prend la forme de la couche de céramique préalablement séparée dudit substrat.

Selon une variante alternative du premier mode de réalisation, le master 2 peut être constitué au moins partiellement d'un matériau souple comme un élastomère. Par exemple, et de façon non exhaustive, nous pouvons citer le silicone, le PDMS PolyDimethylSiloxane, le caoutchouc, le polybutadiène, le fluoroélastomère, etc...

Quelle que soit la variante de réalisation du premier mode de réalisation, le procédé de fabrication d'un composant horloger comprend une quatrième étape consistant à utiliser E4 le master obtenu par les étapes du procédé décrites précédemment pour fabriquer un deuxième moule 3. Ce deuxième moule 3 est avantageusement réalisé en un matériau souple de sorte qu'il puisse être ôté aisément du master 2. Ce deuxième moule 3 peut, par exemple, être fait en un polymère, notamment en un élastomère comme le PDMS (Polydiméthylsiloxane) ou le silicone.

Cette étape E4 comprend une première sous-étape consistant à circonscrire E41 un volume prévu pour réceptionner un volume 33 d'élastomère qui préfigure le deuxième moule 3 par le biais du master 2 et d'un moyen annexe tel qu'un élément annulaire 7, qui définissent au moins partiellement l'empreinte du moule.

Cette étape E4 comprend ensuite une deuxième sous-étape consistant à couler E42 le volume 33 d'élastomère dans l'empreinte définie par le master 2 et l'élément annulaire 7, comme illustré par la figure 10.

Cette étape E4 comprend ensuite une troisième sous-étape consistant à réticuler E43 le volume d'élastomère 33 de façon à le solidifier dans l'empreinte préalablement définie.

Cette étape E4 comprend ensuite une quatrième sous-étape consistant à séparer E44 le moule 3 en élastomère du master 2 et de l'élément annulaire 7.

Quelle que soit la variante de réalisation du premier mode de réalisation, le procédé de fabrication d'un composant horloger comprend ensuite une cinquième étape consistant à fabriquer E5 un composant horloger 6 à l'aide du deuxième moule 3.

Cette étape E5 comprend, par exemple, des sous-étapes E51, E52, E53, E54 qui sont similaires aux sous-étapes E31', E32', E33', E34' de l'étape E3' de la deuxième variante du premier mode de réalisation de l'invention.

Cette étape E5 peut notamment comprendre une sous-étape consistant à remplir E51 le moule 3 par voie liquide d'un produit comprenant de la poudre de céramique. Cette étape peut, par exemple, comprendre le coulage d'une barbotine ou le coulage d'un gel ou un coulage de coagulation. Dans le cas d'une barbotine, cette dernière peut comprendre une matière liquide, de la poudre de céramique et au moins un adjuvant. La matière liquide peut comprendre de l'eau, un alcool ou un autre solvant organique. La poudre de céramique peut, par exemple, comprendre une zircone, ou une alumine, ou un oxyde, ou un carbure, ou un nitrure. Cette étape peut être réalisée sous vide pour garantir un remplissage parfait sans inclusion d'air.

Cette sous-étape E51 peut être précédée par une sous-étape facultative consistant à préparer au moins une portion de surface du moule 3 ou à déposer un revêtement sur au moins une portion de surface du moule 3, dans le but de faciliter la libération future d'une ébauche du composant 6 du moule 3. En remarque, cette ébauche peut, par exemple, prendre la forme du corps vert préfigurant le composant 6.

L'étape E5 peut ensuite notamment comprendre une sous-étape consistant à consolider E52 le produit positionné dans le moule 3. Cette sous-étape peut notamment comprendre le séchage de la barbotine afin d'obtenir une ébauche du composant 6.

Une sous-étape intermédiaire facultative peut consister en la mise de hauteur de l'ébauche du composant 6, avant libération du moule.

L'étape E5 peut ensuite notamment comprendre une sous-étape consistant à séparer E53 l'ébauche de composant 6 du moule 3. Cette séparation peut, par exemple, être réalisée par attaque chimique ou par traitement à l'aide d'un plasma.

L'étape E5 peut ensuite notamment comprendre une sous-étape consistant à délianter l'ébauche de composant 6 obtenue à l'étape précédente et à la densifier E54 par frittage.

Le composant horloger est préférentiellement fait en une céramique ou en matériau composite. Un tel composant en céramique est préférentiellement en céramique dite technique. Par « céramiques techniques », on désigne les matériaux denses à base d'oxyde d'aluminium ; et/ou d'oxyde de zirconium ; et/ou d'oxyde de zirconium stabilisé notamment avec l'oxyde d'yttrium et/ou l'oxyde de cérium et/ou l'oxyde de magnésium ; et/ou en aluminate de strontium notamment dopé ; et/ou de nitrures ; et/ou de carbures ; et être optionnellement pigmenté notamment par des oxydes métalliques et/ou des oxydes métalliques mixtes et/ou des phases spinelles. Pour simplifier la description, nous pouvons utiliser le terme « céramique » pour désigner les « céramiques techniques » pouvant constituer le composant 6. Par « dense », on considère un matériau dont la densité est comprise entre 95 et 100% de la densité théorique du matériau considéré. On note que la notion « à base de » signifie ici que le composant chimique désigné représente au moins 50% en poids de la composition chimique globale de la céramique concernée. En remarque, la céramique technique utilisée pour former le composant diffère a priori de la céramique éventuellement utilisée pour former le moule.

Dans un deuxième mode de réalisation de l'invention, la deuxième structure 1 est destinée à former, au moins partiellement, un master 2' pour moule 3' de fabrication d'un composant horloger 6. A la fin de la deuxième étape E2, l'assemblage des deux résines photosensibles 31, 32 mises en forme selon respectivement les deux motifs décrits ci-dessus forme une deuxième structure 1 solidaire du substrat 20.

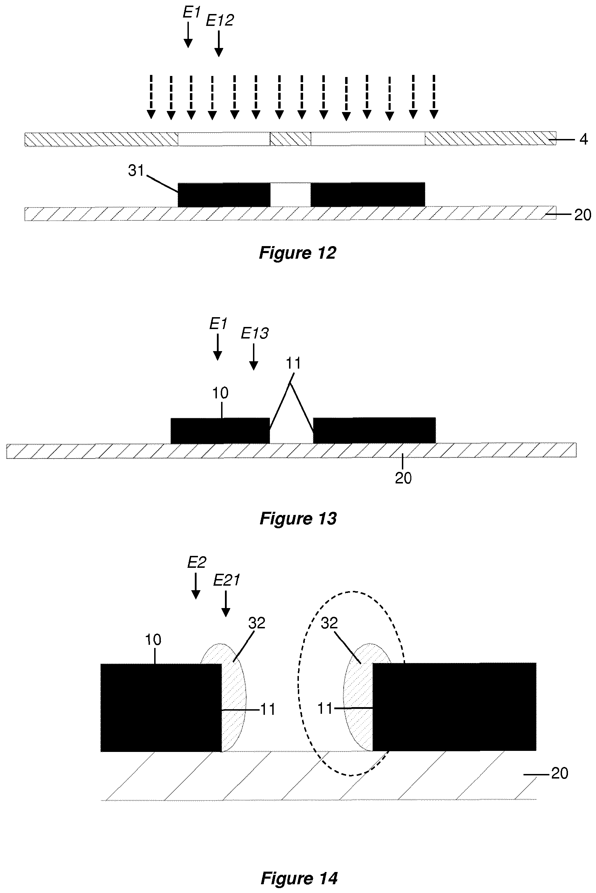

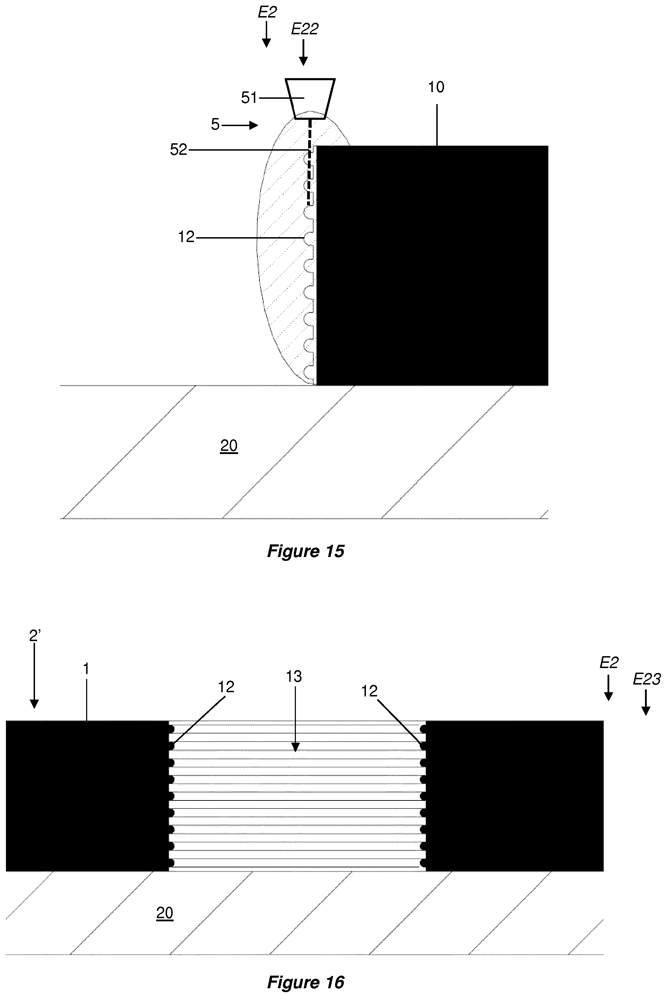

Les figures 12 à 16 illustrent les étapes successives d'un procédé de fabrication d'un master 2' prévu pour permettre la fabrication d'un moule 3' du cliquet d'automate représenté par les figures 1 et 2 selon ce deuxième mode de réalisation de l'invention. Cette deuxième structure 1 est destinée ici à former, complémentairement avec le substrat 20, un master 2' de fabrication d'un moule 3' d'un composant horloger 6. Alternativement, le master 2' ne comprend pas le substrat 20 et prend la forme de la deuxième structure 1, cette dernière étant préalablement séparée dudit substrat. Ainsi, au contraire du premier mode de réalisation, la deuxième structure 1 forme ici directement le master 2', et non un moule de fabrication pour un master.

Dans ce deuxième mode de réalisation, la deuxième structure 1 peut comprendre au moins une cavité 13.

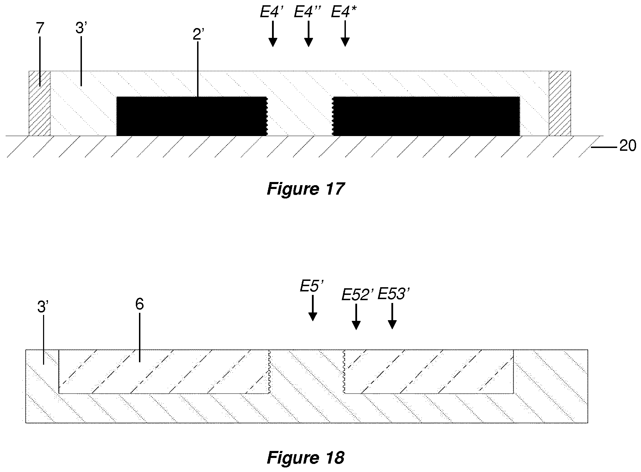

Dans ce deuxième mode de réalisation, le procédé de fabrication d'un composant horloger comprend une troisième étape consistant à utiliser E4', E4", E4* le master 2' pour fabriquer un moule 3', comme illustré par la figure 17.

Selon une première variante du deuxième mode de réalisation, ce moule 3' est avantageusement réalisé en un matériau souple de sorte à ce qu'il puisse être ôté aisément du master 2'. Ce moule 3' peut, par exemple, être fait en un polymère, notamment en un élastomère comme le PDMS (Polydiméthylsiloxane) ou le silicone.

Selon cette première variante du deuxième mode de réalisation, le procédé de fabrication d'un composant horloger comprend une troisième étape consistant à utiliser E4' le master 2' pour fabriquer un moule 3' comme représenté sur la figure 17. L'étape E4' peut, par exemple, comprendre des sous-étapes E41', E42', E43', E44' similaires aux sous-étapes E41, E42, E43, E44 de l'étape E4, qui ont été précédemment décrites.

Dans des deuxième et troisième variantes du deuxième mode de réalisation, le moule 3' peut être rigide. Dans ce cas, le master 2' peut être sacrificiel.

Selon une deuxième variante du deuxième mode de réalisation, le moule 3' résulte d'une croissance d'une couche de métal ou d'un alliage de métal sur le substrat 20. Ainsi, le moule 3' est préférentiellement constitué du substrat 20, de l'éventuelle couche 21, et de la couche de métal ou de l'alliage de métal ayant crû sur ledit substrat. Alternativement, le moule 3' ne comprend pas le substrat 20 et prend la forme de la couche de métal ou de l'alliage de métal ayant crû sur le substrat, cette dernière étant préalablement séparée dudit substrat. Le moule 3' comprend ici au moins une cavité.

Selon cette deuxième variante du deuxième mode de réalisation, la troisième étape consistant à utiliser E4" le master 2' pour fabriquer un moule 3' comprend des sous-étapes E41", E42", E43" qui sont similaires aux sous-étapes E31, E32, E33 de l'étape E3 de la première variante du premier mode de réalisation de l'invention.

Selon une troisième variante du deuxième mode de réalisation, le moule 3' résulte d'une formation d'une couche de céramique sur le substrat 20. Ainsi, le moule 3' est préférentiellement constitué du substrat 20, de l'éventuelle couche 21, et de la couche de céramique formée sur ledit substrat. Alternativement, le moule 3' ne comprend pas le substrat 20 et prend la forme de la couche de céramique sur le substrat, cette dernière étant préalablement séparée dudit substrat. Le moule 3' comprend ici au moins une cavité.

Selon cette troisième variante du deuxième mode de réalisation, la troisième étape consistant à utiliser E4* le master 2' pour fabriquer un moule 3' comprend des sous-étapes E41*, E42*, E43*, E44* qui sont similaires aux sous-étapes E31', E32', E33', E34' de l'étape E3' de la deuxième variante du premier mode de réalisation de l'invention.

Quelle que soit la variante de réalisation du deuxième mode de réalisation, le procédé de fabrication d'un composant horloger comprend ensuite une quatrième étape consistant à fabriquer E5' un composant horloger 6 à l'aide du moule 3'.

L'étape E5' peut notamment comprendre des sous-étapes E51', E52', E53', E54' qui sont similaires aux sous-étapes E51, E52, E53, E54 de l'étape E5, qui ont été préalablement décrites.

Dans le cas d'un moule 3' rigide, le composant 6 ou l'ébauche de composant 6 peut être ôté du moule 3' en tirant profit du retrait du matériau constituant le composant ou l'ébauche du composant 6.

Le procédé de fabrication d'un composant horloger précédemment décrit peut être utilisé pour la fabrication de tous composants horlogers tels que, à titre d'exemples illustratifs et non limitatifs, un balancier, une ancre, un sautoir, un pignon, une roue, une bascule, un ressort, un balancier, une came, ou encore une ébauche. Il peut notamment naturellement être utilisé pour fabriquer tout élément comprenant une microstructure.

Il apparaît donc que l'invention atteint les objets recherchés en combinant avantageusement deux technologies différentes. La photolithographie traditionnelle permet de former le volume principal du master prévu pour permettre la fabrication d'un moule de composant horloger, de manière simple, rapide et fiable par une première étape, et la technologie de polymérisation à deux photons permet d'ajouter des formes complexes à ce volume principal, par une deuxième étape plus complexe et moins rapide mais plus précise et souple, permettant de définir tout motif tridimensionnel. Il en résulte un master pour moule de composant horloger de forme complexe, fabriqué de manière simple et robuste.

## Revendications

1. Procédé de fabrication d'un master (2) pour moule (3) de composant horloger, comprenant au moins les étapes suivantes:
- Fabriquer (E1) une première structure (10) à partir d'une première résine (31) photosensible comprenant au moins une couche de résine photosensible comprenant un premier motif obtenu par polymérisation de la première résine photosensible par irradiation à travers au moins un masque (4), puis développement de ladite première résine photosensible ;
- Transformer (E2) la première structure (10) en une deuxième structure (1) par une structuration d'au moins une surface (11) de la première structure par ajout d'une deuxième résine photosensible (32) sur ladite au moins une surface, cette étape consistant à transformer (E2) la première structure comprenant les étapes suivantes :
o Déposer (E21) une couche de la deuxième résine photosensible (32) sur au moins une partie de l'au moins une surface (11) de la première structure ;
o Polymériser à deux photons (E22) la deuxième résine photosensible (32) pour obtenir une polymérisation tridimensionnelle selon le deuxième motif, en utilisant un dispositif photonique qui comporte un objectif (51) qui est au moins partiellement immergé dans la deuxième résine pour diriger et focaliser un faisceau (52) sur des voxels définissant la forme et/ou la géométrie du deuxième motif;
o Développer (E23) pour éliminer la deuxième résine photosensible (32) non polymérisée et obtenir la deuxième structure (1) de forme définie par les premier et deuxième motifs, dans lequel procédé
la deuxième structure (1) forme directement le master (2) d'un moule (3) de composant horloger ou elle forme un moule (3) pour la fabrication par moulage d'un master (2) pour moule de composant horloger.

2. Procédé de fabrication d'un master (2) pour moule (3) de composant horloger selon la revendication précédente, **caractérisé en ce que** l'étape consistant à transformer (E2) la première structure (10) comprend l'ajout de la deuxième résine photosensible (32) sur au moins une surface latérale (11) de la première structure.

3. Procédé de fabrication d'un master (2) pour moule (3) de composant horloger selon l'une des revendications précédentes, **caractérisé en ce que** l'étape consistant à transformer (E2) la première structure comprend le dépôt (E21) de la deuxième résine photosensible (32) sur ladite au moins une surface (11), la polymérisation tridimensionnelle (E22) de cette deuxième résine selon un deuxième motif et le développement (E23) de la deuxième résine.

4. Procédé de fabrication d'un master (2) pour moule (3) de composant horloger selon l'une des revendication 1 à 3, **caractérisé en ce que** l'étape consistant à polymériser à deux photons (E22) permet de définir un deuxième motif selon une résolution tridimensionnelle inférieure ou égale à 0.001 µm³ et/ou selon une résolution latérale inférieure ou égale à 0.1 µm.

5. Procédé de fabrication d'un master pour moule de composant horloger selon la revendication précédente, **caractérisé en ce que** la première structure (10) est fabriqué sur un substrat (20) et **en ce que** l'étape consistant à exposer (E12) la première résine (31) génère une première structure (10) comprenant des flancs latéraux perpendiculaires ou sensiblement perpendiculaires au substrat (20) et/ou une section parallèle ou sensiblement parallèle au substrat (20) constante.

6. Procédé de fabrication d'un master (2) pour moule (3) de composant horloger selon l'une des revendications précédentes, **caractérisé en ce que** :
- Les deux résines (31, 32) sont identiques ou différentes ; et/ou
- Les deux résines (31, 32) sont positives ou négatives ; et/ou
- La première résine (31) est de type « SU-8 » ou de type « SU-8-100 » ; et/ou
- La deuxième résine (32) est une résine liquide ou semi-liquide, notamment IP-Dip^{™}.

7. Procédé de fabrication d'un master (2) pour moule (3) de composant horloger selon l'une des revendications précédentes, **caractérisé en ce qu'**il comprend les étapes suivantes :
- Déposer (E31) une couche de métal (22) formant au moins partiellement le master pour moule de composant horloger, par électrodéposition ou dépôt galvanique dans la deuxième structure (1);
- Séparer (E33) le master pour moule de composant horloger, formé par ladite couche de métal, de ladite deuxième structure.

8. Procédé de fabrication d'un master (2) pour moule (3) de composant horloger selon la revendication précédente, **caractérisé en ce que** le métal (22) est à base de nickel ou est un alliage de nickel-phosphore.

9. Procédé de fabrication d'un master (2) pour moule (3) de composant horloger selon l'une des revendications 1 à 6, **caractérisé en ce qu'**il comprend les étapes suivantes :
- Remplir (E31') la deuxième structure (1) par voie liquide d'un produit comprenant de la poudre de céramique ;
- Consolider (E32') ledit produit ;
- Séparer (E33') l'ébauche formée par ledit produit de ladite deuxième structure (1);
- Délianter l'ébauche obtenue à l'étape précédente puis la densifier (E34') par frittage.

10. Procédé de fabrication d'un composant horloger (6), **caractérisé en ce qu'**il comprend une étape consistant à fabriquer un master (2 ; 2') par un procédé selon l'une des revendications précédentes, une étape consistant à utiliser ce master pour fabriquer (E4 ; E4' ; E4"; E4*) un moule (3 ; 3') de fabrication d'un composant horloger, puis une étape consistant à utiliser ledit moule (3 ; 3') comme moule de fabrication pour fabriquer (E5 ; E5') le composant horloger, ce dernier pouvant être en céramique, notamment en céramique technique.

11. Procédé de fabrication d'un composant horloger (6) selon la revendication précédente, **caractérisé en ce que** le moule (3 ; 3') est fabriqué en un polymère, notamment en un élastomère comme le PDMS, Polydiméthylsiloxane, ou le silicone.

12. Procédé de fabrication d'un composant horloger (6) selon la revendication précédente, **caractérisé en ce que** l'étape consistant à utiliser ce master (2, 2') pour fabriquer (E4 ; E4') un moule (3 ; 3') comprend les sous-étapes suivantes :
- Circonscrire (E41 ; E41') par un élément annulaire (7) un volume prévu pour réceptionner un volume de polymère, en complément du master (2 ; 2') ;
- Couler (E42 ; E42') un volume d'élastomère dans l'empreinte formée par le master (2 ; 2') complété par l'élément annulaire (7) ;
- Réticuler (E43 ; E43') le volume d'élastomère de façon à le solidifier ;
- Séparer (E44 ; E44') le moule (3 ; 3') en élastomère du master (2 ; 2') et de l'élément annulaire (7).

13. Procédé de fabrication d'un composant horloger (6) selon la revendication 10, **caractérisé en ce que** le moule (3 ; 3') est fabriqué en métal ou alliage métallique ou en céramique.

14. Procédé de fabrication d'un composant horloger (6) selon l'une des revendications 10 à 13, **caractérisé en ce que** l'étape consistant à fabriquer (E5 ; E5') le composant horloger comprend sa fabrication en céramique technique par les sous-étapes suivantes ;
- Remplir (E51 ; E51') le moule (3 ; 3') par voie liquide d'un produit comprenant de la poudre de céramique ;
- Consolider (E52 ; E52') ledit produit ;
- Séparer (E53 ; E53') l'ébauche formée par ledit produit du moule (3 ; 3') de fabrication;
- Délianter l'ébauche obtenue à l'étape précédente puis la densifier (E54 ; E54') par frittage.

## Patentansprüche

1. Verfahren zur Herstellung eines Masters (2) für eine Form (3) einer Uhrenkomponente, beinhaltend mindestens die folgenden Schritte:
- Herstellen (E1) einer ersten Struktur (10) aus einem ersten lichtempfindlichen Harz (31), beinhaltend mindestens eine Schicht aus lichtempfindlichem Harz, die ein erstes Muster beinhaltet, das durch Polymerisation des ersten lichtempfindlichen Harzes mittels Bestrahlung durch mindestens eine Maske (4) hindurch erhalten wird, dann Entwickeln des ersten lichtempfindlichen Harzes;
- Umwandeln (E2) der ersten Struktur (10) in eine zweite Struktur (1) durch eine Strukturierung mindestens einer Oberfläche (11) der ersten Struktur durch Hinzufügen eines zweiten lichtempfindlichen Harzes (32) zu der mindestens einen Oberfläche, wobei dieser Schritt, der darin besteht, die erste Struktur umzuwandeln (E2), die folgenden Schritte beinhaltet:
o Abscheiden (E21) einer Schicht des zweiten lichtempfindlichen Harzes (32) auf mindestens einem Teil der mindestens einen Oberfläche (11) der ersten Struktur;
o Durchführen einer Zwei-Photonen-Polymerisation (E22) an dem zweiten lichtempfindlichen Harz (32), um eine dreidimensionale Polymerisation gemäß dem zweiten Muster zu erhalten, unter Verwendung einer photonischen Vorrichtung, die ein Objektiv (51) umfasst, das mindestens teilweise in das zweite Harz eingetaucht ist, um einen Strahl (52) auf Voxel, die die Form und/oder die Geometrie des zweiten Musters definieren, zu lenken und zu fokussieren;
o Entwickeln (E23), um das zweite, nicht polymerisierte lichtempfindliche Harz (32) zu entfernen und die zweite Struktur (1) mit einer durch das erste und das zweite Muster definierten Form zu erhalten, wobei in dem Verfahren die zweite Struktur (1) direkt den Master (2) einer Form (3) einer Uhrenkomponente bildet oder sie eine Form (3) zur Herstellung eines Masters (2) für eine Form einer Uhrenkomponente durch Formen bildet.

2. Verfahren zur Herstellung eines Masters (2) für eine Form (3) einer Uhrenkomponente nach dem vorhergehenden Anspruch, **dadurch gekennzeichnet, dass** der Schritt, der darin besteht, die erste Struktur (10) umzuwandeln (E2), das Hinzufügen des zweiten lichtempfindlichen Harzes (32) zu mindestens einer lateralen Oberfläche (11) der ersten Struktur beinhaltet.

3. Verfahren zur Herstellung eines Masters (2) für eine Form (3) einer Uhrenkomponente nach einem der vorhergehenden Ansprüche, **dadurch gekennzeichnet, dass** der Schritt, der darin besteht, die erste Struktur umzuwandeln (E2), die Abscheidung (E21) des zweiten lichtempfindlichen Harzes (32) auf der mindestens einen Oberfläche (11), die dreidimensionale Polymerisation (E22) dieses zweiten Harzes gemäß einem zweiten Muster und die Entwicklung (E23) des zweiten Harzes beinhaltet.

4. Verfahren zur Herstellung eines Masters (2) für eine Form (3) einer Uhrenkomponente nach einem der Ansprüche 1 bis 3, **dadurch gekennzeichnet, dass** der Schritt, der darin besteht, die Zwei-Photonen-Polymerisation durchzuführen (E22), es gestattet, ein zweites Muster gemäß einer dreidimensionalen Auflösung kleiner als oder gleich 0,001 µm³ und/oder gemäß einer lateralen Auflösung kleiner als oder gleich 0,1 µm zu definieren.

5. Verfahren zur Herstellung eines Masters für eine Form einer Uhrenkomponente nach dem vorhergehenden Anspruch, **dadurch gekennzeichnet, dass** die erste Struktur (10) auf einem Substrat (20) hergestellt wird und dass der Schritt, der darin besteht, das erste Harz (31) zu belichten (E12), eine erste Struktur (10) erzeugt, die laterale Flanken senkrecht oder im Wesentlichen senkrecht zu dem Substrat (20) und/oder einen parallel oder im Wesentlichen parallel zu dem Substrat (20) verlaufenden konstanten Abschnitt beinhaltet.

6. Verfahren zur Herstellung eines Masters (2) für eine Form (3) einer Uhrenkomponente nach einem der vorhergehenden Ansprüche, **dadurch gekennzeichnet, dass**:
- die zwei Harze (31, 32) identisch oder verschieden sind; und/oder
- die zwei Harze (31, 32) positiv oder negativ sind; und/oder
- das erste Harz (31) vom Typ "SU-8" oder vom Typ "SU-8-100" ist; und/oder
- das zweite Harz (32) ein flüssiges oder halbflüssiges Harz, insbesondere IP-Dip^{™}, ist.

7. Verfahren zur Herstellung eines Masters (2) für eine Form (3) einer Uhrenkomponente nach einem der vorhergehenden Ansprüche, **dadurch gekennzeichnet, dass** es die folgenden Schritte beinhaltet:
- Abscheiden (E31) einer Metallschicht (22), die mindestens teilweise den Master für eine Form einer Uhrenkomponente bildet, durch Elektroabscheidung oder galvanische Abscheidung in der zweiten Struktur (1);
- Trennen (E33) des Masters für eine Form einer Uhrenkomponente, der durch die Metallschicht gebildet wird, von der zweiten Struktur.

8. Verfahren zur Herstellung eines Masters (2) für eine Form (3) einer Uhrenkomponente nach dem vorhergehenden Anspruch, **dadurch gekennzeichnet, dass** das Metall (22) auf Nickelbasis ist oder eine Nickel-Phosphor-Legierung ist.

9. Verfahren zur Herstellung eines Masters (2) für eine Form (3) einer Uhrenkomponente nach einem der Ansprüche 1 bis 6, **dadurch gekennzeichnet, dass** es die folgenden Schritte beinhaltet:
- Füllen (E31') der zweiten Struktur (1) auf flüssigem Wege mit einem Produkt, das Keramikpulver beinhaltet;
- Konsolidieren (E32') des Produkts;
- Trennen (E33') des durch das Produkt gebildeten Rohlings von der zweiten Struktur (1);
- Entbindern des im vorhergehenden Schritt erhaltenen Rohlings, dann Verdichten (E34') desselben durch Sintern.

10. Verfahren zur Herstellung einer Uhrenkomponente (6), **dadurch gekennzeichnet, dass** es einen Schritt, der darin besteht, einen Master (2; 2') durch ein Verfahren nach einem der vorhergehenden Ansprüche herzustellen, einen Schritt, der darin besteht, diesen Master zu verwenden, um eine Form (3; 3') zur Herstellung einer Uhrenkomponente herzustellen (E4; E4'; E4"; E4*), dann einen Schritt, der darin besteht, die Form (3; 3') als Herstellungsform zu verwenden, um die Uhrenkomponente herzustellen (E5; E5'), wobei letztere aus Keramik, insbesondere aus technischer Keramik, sein kann, beinhaltet.

11. Verfahren zur Herstellung einer Uhrenkomponente (6) nach dem vorhergehenden Anspruch, **dadurch gekennzeichnet, dass** die Form (3; 3') aus einem Polymer, insbesondere einem Elastomer wie etwa PDMS, Polydimethylsiloxan, oder Silikon, hergestellt ist.

12. Verfahren zur Herstellung einer Uhrenkomponente (6) nach dem vorhergehenden Anspruch, **dadurch gekennzeichnet, dass** der Schritt, der darin besteht, diesen Master (2, 2') zu verwenden, um eine Form (3; 3') herzustellen (E4; E4'), die folgenden Unterschritte beinhaltet:
- Umgrenzen (E41; E41') eines Volumens, das dazu vorgesehen ist, ein Polymervolumen aufzunehmen, mit einem ringförmigen Element (7) als Ergänzung zu dem Master (2;2');
- Gießen (E42; E42') eines Elastomervolumens in den Raum, der durch den Master (2; 2'), ergänzt durch das ringförmige Element (7), gebildet wird;
- Vernetzen (E43; E43') des Elastomervolumens, um es zu verfestigen;
- Trennen (E44; E44') der Form (3; 3') aus Elastomer von dem Master (2; 2') und dem ringförmigen Element (7).

13. Verfahren zur Herstellung einer Uhrenkomponente (6) nach Anspruch 10, **dadurch gekennzeichnet, dass** die Form (3; 3') aus Metall oder einer Metalllegierung oder aus Keramik hergestellt wird.

14. Verfahren zur Herstellung einer Uhrenkomponente (6) nach einem der Ansprüche 10 bis 13, **dadurch gekennzeichnet, dass** der Schritt, der darin besteht, die Uhrenkomponente herzustellen (E5; E5'), ihre Herstellung aus technischer Keramik durch die folgenden Unterschritte beinhaltet;
- Füllen (E51; E51') der Form (3; 3') auf flüssigem Wege mit einem Produkt, das Keramikpulver beinhaltet;
- Konsolidieren (E52; E52') des Produkts;
- Trennen (E53; E53') des durch das Produkt gebildeten Rohlings von der Herstellungsform (3; 3');
- Entbindern des im vorhergehenden Schritt erhaltenen Rohlings, dann Verdichten (E54; E54') desselben durch Sintern.

## Claims

1. A method for manufacturing a master pattern (2) for a mold (3) for a horology component, comprising at least the following steps:
- Manufacturing (E1) a first structure (10) from a first photosensitive resin (31) comprising at least one layer of photosensitive resin comprising a first pattern obtained by polymerizing the first photosensitive resin by irradiation through at least one mask (4), then developing said first photosensitive resin;
- Transforming (E2) the first structure (10) into a second structure (1) by structuring at least one surface (11) of the first structure by the addition of a second photosensitive resin (32) to said at least one surface, this step consisting in transforming (E2) the first structure comprising the following steps:
∘ Applying (E21) a layer of the second photosensitive resin (32) on at least part of the at least one surface (11) of the first structure;
∘ Performing two-photon polymerization (E22) on the second photosensitive resin (32) in order to obtain three-dimensional polymerization according to the second pattern, using a photon device which comprises an objective (51) which is at least partially immersed in the second resin to direct and focus a beam (52) on voxels that define the shape and/or the geometry of the second pattern;
∘ Developing (E23) in order to eliminate the non-polymerized second photosensitive resin (32) and obtain the second structure (1) of a form defined by the first and second patterns, wherein in said method the the second structure (1) directly forms the master pattern (2) of a mold (3) for a horology component or forms a mold (3) for the manufacture by molding of a master pattern (2) of a mold (3) for a horology component.

2. The method for manufacturing a master pattern (2) for a mold (3) for a horology component as claimed in the preceding claim, **characterized in that** the step consisting in transforming (E2) the first structure (10) comprises the addition of the second photosensitive resin (32) on at least one lateral surface (11) of the first structure.

3. The method for manufacturing a master pattern (2) for a mold (3) for a horology component as claimed in one of the preceding claims, **characterized in that** the step consisting in transforming (E2) the first structure comprises the application (E21) of the second photosensitive resin (32) on said at least one surface (11), the three-dimensional polymerization (E22) of this second resin according to a second pattern, and the developing (E23) of the second resin.

4. The method for manufacturing a master pattern (2) for a mold (3) for a horology component as claimed in one of claims 1 to 3, **characterized in that** the step that consists in performing two-photon polymerization (E22) makes it possible to define a second pattern with a three-dimensional resolution better than or equal to 0.001 µm³ and/or with a lateral resolution better than or equal to 0.1 µm.

5. The method for manufacturing a master pattern for a mold for a horology component as claimed in the preceding claim, **characterized in that** the step consisting in exposing (E12) the first resin (31) generates a first structure (10) comprising lateral flanks perpendicular or substantially perpendicular to the substrate (20) and/or a constant cross section parallel or substantially parallel to the substrate (20).

6. The method for manufacturing a master pattern (2) for a mold (3) for a horology component as claimed in one of the preceding claims, **characterized in that**:
- The two resins (31, 32) are identical or different; and/or
- The two resins (31, 32) are positive or negative; and/or
- The first resin (31) is of SU-8 type or of SU-8-100 type; and/or
- The second resin (32) is a liquid or semiliquid resin, notably IP-Dip^{™}.

7. The method for manufacturing a master pattern (2) for a mold (3) for a horology component as claimed in one of the preceding claims, **characterized in that** it comprises the following steps:
- Using electrodeposition or electroplating to apply (E31) to the second structure (1) a layer of metal (22) that at least partially forms the master pattern for the mold for the horology component;
- Separating (E33) from said second structure the master pattern for the mold for the horology component which is formed by said layer of metal.

8. The method for manufacturing a master pattern (2) for a mold (3) for a horology component as claimed in the preceding claim, **characterized in that** the metal (22) is nickel-based or is a nickel-phosphorus alloy.

9. The method for manufacturing a master pattern (2) for a mold (3) for a horology component as claimed in one of claims 1 to 6, **characterized in that** said method comprises the following steps:
- Using a liquid route to fill (E31') the second structure (1) with a product containing ceramic powder;
- Consolidating (E32') said product;
- Separating (E33') from said second structure (1) the blank formed by said product;
- Debinding the blank obtained in the preceding step, then densifying it (E34') by sintering.

10. A method for manufacturing a horology component (6), **characterized in that** it comprises a step consisting in manufacturing a master pattern (2; 2') using a method as claimed in one of the preceding claims, a step consisting in using this master pattern to manufacture (E4; E4'; E4"; E4*) a mold (3; 3') for manufacturing a horology component, and then a step consisting in using said mold (3; 3') as a manufacturing mold to manufacture (E5; E5') the horology component, it being possible for the latter to be made of ceramic, notably of technical ceramic.

11. The method for manufacturing a horology component (6) as claimed in the preceding claim, **characterized in that** the mold (3; 3') is manufactured from a polymer, notably from an elastomer such as PDMS (polydimethylsiloxane) or silicone.

12. The method for manufacturing a horology component (6) as claimed in the preceding claim, **characterized in that** the step consisting in using this master pattern to manufacture (E4; E4') a mold (3; 3') comprises the following substeps:
- circumscribing (E41; E41'), with an annular element (7), a volume intended to receive a volume of polymer, to complement the master pattern (2; 2');
- pouring (E42; E42') a volume of elastomer into the impression cavity formed by the master pattern (2; 2') completed by the annular element (7);
- polymerizing (E43; E43') the volume of elastomer so as to solidify it;
- separating (E44; E44') the elastomer mold (3; 3') from the master pattern (2; 2') and from the annular element (7).

13. The method for manufacturing a horology component (6) as claimed in claim 10, **characterized in that** the mold (3; 3') is manufactured in metal or in metal alloy or in ceramic.

14. The method for manufacturing a horology component (6) as claimed in one of claims 10 to 13, **characterized in that** the step consisting in manufacturing (E5; E5') the horology component comprises manufacturing it in technical ceramic using the following substeps:
- using a liquid route to fill (E51; E51') the mold (3; 3') with a product containing ceramic powder;
- consolidating (E52; E52') said product;
- separating (E53; E53') the blank formed by said product from the manufacturing mold (3; 3');
- debinding the blank obtained in the preceding substep, then densifying it (E54; E54') by sintering.
